# EUROPÄISCHE PATENTSCHRIFT

(11) **EP 0 917 597 B1**
(45) Veröffentlichungstag und Bekanntmachung des Hinweises auf die Patenterteilung: **15.01.2003**
(21) Anmeldenummer: 98937438.4
(22) Anmeldetag: 03.06.1998
(51) Int. Cl.: C23C 18/00

(54) **VERFAHREN ZUR HERSTELLUNG LEITERBAHNSTRUKTUREN, INSBESONDERE FEINER LEITERBAHNSTRUKTUREN AUF EINEM NICHTLEITENDEN TRÄGERMATERIAL**
METHOD FOR PRODUCING CONDUCTOR TRACK STRUCTURES, ESPECIALLY FINE CONDUCTOR TRACK STRUCTURES, ARRANGED ON A NONCONDUCTIVE SUPPORT MATERIAL
PROCEDE DE PRODUCTION DE STRUCTURES DE PISTES CONDUCTRICES, EN PARTICULIER DE STRUCTURES FINES DE PISTES CONDUCTRICES, DISPOSEES SUR UN MATERIAU SUPPORT NON CONDUCTEUR

(30) Priorität: 06.06.1997 DE 19723734
(43) Veröffentlichungstag der Anmeldung: 26.05.1999
(73) Patentinhaber: LPKF Laser & Electronics AG, 30827 Garbsen (DE)
(72) Erfinder: Naundorf, Gerhard, Prof. Dr., 32657 Lemgo (DE); Wissbrock, Horst, Prof. Dr., 32760 Delmond (DE)
(74) Vertreter: Braun, Dieter, Dipl.-Ing.
(86) Internationale Anmeldenummer: EP9803303
(87) Internationale Veröffentlichungsnummer: WO98055669

(56) Entgegenhaltungen:
- DE-A- 2 323 507
- DE-A1- 2 451 217
- US-A- 4 900 581

## Beschreibung

Die Erfindung betrifft ein Verfahren zur Herstellung von Leiterbahnstrukturen auf einem nichtleitenden Trägermaterial, insbesondere feine Leiterbahnstrukturen, gemäß dem Oberbegriff des Anspruchs 1.

Durch den Sonderdruck "LAD - Ein neuartiges lasergestütztes Beschichtungsverfahren für Feinstleitermetallisierungen" aus Heft Nummer 10, Band 81 (1990), der Fachzeitschrift "Galvanotechnik", ist es bekannt geworden, zur Herstellung von Feinstleiterstrukturen von deutlich unter 100 mm auf einem nichtleitenden Trägermaterial vollflächig Pd-Acetat aus einer Lösung als dünnen Film aufzubringen. Durch eine nachfolgende Laserbelichtung mittels eines Excimerlasers mit einer Wellenlänge von 248 nm sollen dann im Bereich der zu erzeugenden Leiterbahnstrukturen Metallatome als Keime für eine nachfolgende stromlose Metallisierung freigesetzt werden. Vor der Metallisierung ist es jedoch erforderlich, einen Spülprozeß zur Entfernung der unzersetzten Bereiche des auf das Trägermaterial aufgebrachten metallhaltigen Filmes durchzuführen. Der Qualität dieses Spülprozesses kommt dabei eine entscheidende Rolle für die Vermeidung von Wildwuchsproblemen bei der nachfolgenden stromlosen Metallisierung zu. Im übrigen hat es sich gezeigt, daß mittels des beschriebenen Verfahrens keine ausreichende Haftfestigkeit der abgeschiedenen metallischen Leiterbahnen erzielbar ist.

In der DE 42 10 400 C1 ist auch bereits ein Verfahren zur direkten Abscheidung von Kupfer, aus einem auf ein Substrat aufgebrachten Film aus einem Gemisch von Schwermetallsalzen durch lokales Erhitzen mittels eines Lasers beschrieben. Bei dem aufgebrachten Film handelt es sich um einen elektrisch leitenden Film, so daß auch hier vor der Metallisierung ein aufwendiger und problematischer Spülprozeß erforderlich ist.

Aus der US-A-4,900,581 ist es bekannt, selektiv auf mit Excimer-Laserlicht belichtete Substratbereiche ein Metall, wie Palladium, aus einem Metallsalz, wie Palladiumdiacetat, in elementarer Form abzuscheiden. Das beschriebene Verfahren wird dazu benutzt, mittels nachfolgender stromloser Metallisierung, die auf die entstandenen Metallkeime erfolgen kann, feine Leiterbahnstrukturen auf den belichteten Substratbereichen herzustellen. Da die Beschichtung elektrisch leitfähig ist, ist es jedoch auch hier jedoch erforderlich, die unbelichteten Bereiche mittels eines Spülprozesses zu entfemen.

Umgekehrt ist es aus der DE-A-2323507 auch bereits bekannt, Leiterbahnstrukturen auf mit einer kolloidalen Palladium, Gold- oder Platin- Sensibilisierungslösung behandelte Bereiche eines Substrates aufzubringen, die nicht mit Excimer-Laserlicht belichtet wurden.

In der DE 41 24 686 A1 ist u. a. ein Verfahren beschrieben, bei dem Metallkomplexe durch Tauchen oder Aufsprühen aufgetragen und ein Aufbrechen der Komplexe mittels Photolyse erfolgen kann. Der Auftrag der Metallkomplexe erfolgt hier jedoch stets nur dort, wo eine leitfähige Beschichtung bzw. auch Leiterbahnen erzeugt werden sollen.

Durch die US 45 74 095 ist ein Verfahren bekannt geworden, bei dem ein Substrat in einer Vakuumkammer dem Dampf einer Palladium-Komplexverbindung ausgesetzt wird und dann durch ein Fenster strukturierend mit einem 249nm-Eximerlaser bestrahlt wird. Auch dieses Verfahren ist, da die Palladium-Abscheidung aus einer dampfförmigen Phase in einer Vakuumkammer erfolgt, so aufwendig, daß ein Einsatz im Bereich konventioneller Leiterplatten und Schaltungsträger nicht wirtschaftlich ist.

Aufgabe der Erfindung ist es, einfach und sicher herzustellende feine Leiterbahnstrukturen elektrischer Schaltungen zur Verfügung zu stellen und ferner ein vereinfachtes und sicheres Verfahren zur Herstellung der Leiterbahnstrukturen zu schaffen, das eine Feinststrukturierung der Leiterbahnen bis hin zu Leiterbahnbreiten und -abständen von 10 µm sicher gewährleistet.

Diese Aufgabe wird durch die Merkmale des Anspruchs 1 gelöst. Die weiteren Ausgestaltungen der Erfindung sind den jeweils zugehörigen Unteransprüchen zu entnehmen. Indem bei Leiterbahnstrukturen, die auf einem nichtleitenden Trägermaterial durch Aufbrechen eines aufgebrachten Schwermetallchelatkomplexes und nachfolgender Metallisierung entstanden sind, der auf eine mikroporöse Oberfläche aufgebrachte Schwermetallchelatkomplex thermisch hochstabil und auf der Basis von polyfunktionellen Chelatkomplexbildnern mit molekularen Kombinationen von sterisch gehinderten Aromaten und metallkomplexierenden Gruppen gebildet ist, wird erreicht, daß der Schwermetallchelatkomplex auf dem Trägermaterial verbleiben kann und im Umfeld der Leiterbahnstrukturen dessen Oberfläche bildet. Wie sich gezeigt hat, sind nämlich derartige Schwermetallchelatkomplexe derart temperaturbeständig, daß sie bei Löttemperaturen stabil bleiben, d. h. insbesondere auch nicht etwa elektrisch leitend werden. Zudem sind die Schwermetallchelatkomplexe auch in den für die Metallisierung eingesetzten wäßrigen Metallisierungsbädem stabil. Insgesamt ergibt sich der Vorteil, daß die erfindungsgemäßen Leiterbahnstrukturen im Vergleich zu herkömmlichen Leiterbahnstrukturen, insbesondere auch, da ein Spülprozeß entfällt, überraschend einfach und sicher herzustellen sind. Die Metallisierung erfolgt ohne jeden Wildwuchs unter Ausbildung sehr scharfer Konturen. Außerdem wird eine hervorragende Haftfestigkeit der abgeschiedenen metallischen Leiterbahnen erzielt.

Gemäß einer bevorzugten Ausführungsform der Erfindung ist der Schwermetallchelatkomplex ein Pd-haltiger Schwermetallkomplex oder ein Pd-Komplex.

Bei dem erfindungsgemäßen Verfahren zur Herstellung der Leiterbahnstrukturen ist dadurch, daß als auf das Trägermaterial aufzubringende schwermetallhaltige Komponente ein nichtleitender organischer Schwermetallkomplex verwendet wird, erreicht worden, daß nach der Einwirkung der UV-Strahlung direkt anschließend die chemisch reduktive Metallisierung erfolgen kann. Im Bereich der zu erzeugenden Leiterbahnstrukturen erfolgt durch die Einwirkung der UV-Strahlung ein Aufbrechen des Schwermetallkomplexes, wodurch für die partielle reduktive Metallisierung hochreaktive Schwermetallkeime abgespalten werden. Ein durchaus problematischer Spülprozeß ist nicht erforderlich. Die Metallisierung erfolgt dennoch ohne jeden Wildwuchs unter Ausbildung sehr scharfer Konturen. Da die gebildeten Schwermetallkeime hochreaktiv sind, wird die erwünschte exakte Metallisierung in der erforderlichen Schichtdicke zusätzlich begünstigt. Vorzugsweise wird ein Pd-Komplex bzw. ein Pd-haltiger Schwermetallkomplex verwendet. Wie sich gezeigt hat, sind derartige Schwermetallkomplexe besonders gut zur Feinststrukturierung gemäß dem erfindungsgemäßen Verfahren geeignet. Insbesondere ist für die Einleitung der strukturierenden Spaltungsreaktion eine UV-Strahlung einer wesentlich geringeren Energiedichte ausreichend, als für das Abtragen bzw. auch für das Auslösen des als Zersetzung beschriebenen Wirkungsmechanismus bei bekannten Systemen. Auch als Folge dieser geringen Energieeinleitung treten keinerlei ablative Partikel auf, so daß auch Reinigungsprozesse vor der Metallisierung entfallen. Zusätzlich wird erreicht, daß im Zusammenhang mit der Strukturierung pro Laserimpuls wesentlich größere Flächen belichtet werden können, als bei bekannten Ablationstechniken.

Im Rahmen der Erfindung ist es außerdem vorgesehen, daß zur Abspaltung der Schwermetallkeime aus dem Schwermetallkomplex vorzugsweise ein Kr F-Excimerlaser mit einer Wellenlänge von 248 nm eingesetzt wird. Es ist so möglich, die Abspaltung ohne Aufheizung des Komplexes durchzuführen. Hierdurch wird ein Aufschmelzen von Materialien im Einwirkungsbereich vermieden. Die Folge ist eine sehr hohe Begrenzungsschärfe der Bereiche mit abgespalteten Schwermetallkeimen und sich daraus ergebend eine sehr hohe, äußerst vorteilhafte Kantenschärfe der metallisierten Strukturen, was insbesondere bei Feinstleitem von großer Bedeutung ist.

Gemäß einer bevorzugten Ausführungsform ist es vorgesehen, daß Palladiumdiacetat mit einem organischen Komplexbildner zu einem Pd-Komplex umgesetzt wird. Wie sich gezeigt hat, ist es vorteilhaft, wenn als organischer Komplexbildner ein an sich bekannter, hochstabiler polyfunktioneller Chelatbildner mit mehreren Ligandenatomen, wie N, O, S, P, eingesetzt wird. Im Rahmen der Erfindung ist es weiterhin vorgesehen, daß der polyfunktionelle Chelatbildner auch zusammen mit ionisierenden Gruppen, wie Hydroxyloder Carboxylgruppen, eingesetzt werden kann.

Insbesondere können als organische Komplexbildner molekulare Kombinationen von sterisch gehinderten Aromaten und metallkomplexierenden Gruppen eingesetzt werden. Vorzugsweise findet dabei ein organischer Komplexbildner der Formel 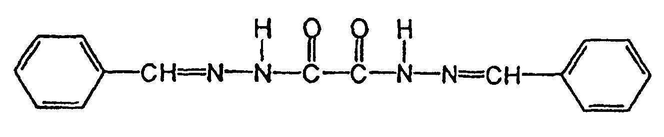 Verwendung.

Grundsätzlich ist es vorgesehen, daß der Schwermetallkomplex in einem Lösungsmittel, bei einem Pd-Komplex vorzugsweise Dimethylformamid, gelöst auf ein poröses Trägermaterial bzw. auf ein Trägermaterial mit poröser Oberfläche aufgetragen wird. Hierbei kann es sich z. B. um eine flexible Polyimid-Folie mit mikroporöser Oberfläche oder aber auch um Papier handeln. Der Pd-Komplex kann hier in die Poren des Materials eindringen. Bei der nachfolgenden Metallisierung ist für die Haftung des Leiterzuges die Porenstruktur vorteilhaft, in die bei der Metallisierung das beispielsweise verwendete Kupfer hineinwächst und sich dann dort wurzelförmig verklammert. Die erzielbaren, sehr feinen Strukturen werden dadurch begünstigt, daß eine Haftvermittlerschicht nicht erforderlich ist und von daher keine untere Grenze möglicher Leiterbahnbreiten vorgegeben ist. Zusätzlich ermöglicht die Excimerlaser-UV-Strahlung aufgrund ihrer Kurzwelligkeit feinste scharf ausgebildete Strukturen mit Metallisierungskeimen.

Alternativ ist es vorgesehen, daß der Schwermetallkomplex in ein Bindemittel, das eine poröse Struktur ausbildet, eingemischt und dann auf das Trägermaterial als Beschichtung aufgebracht wird. Auch ein derartiges Verfahren ist u. a. aufgrund seiner sehr einfachen Handhabung und Zuverlässigkeit für viele Anwendungsfälle durchaus vorteilhaft.

Gemäß der Erfindung wird ein organischer nichtleitender Schwermetallkomplex gleichmäßig auf ein mikroporöses Basismaterial verteilt bzw. in ein Bindemittel, das eine poröse Struktur ausbildet, eingemischt und dann auf das Trägermaterial als Beschichtung aufgebracht. Dann wird der Schwermetallkomplex mittels selektiv aufgebrachter Excimerlaser-UV-Strahlung nur in den zu metallisierenden Zonen so gespalten, daß Metallkeime gebildet werden, die dann in reduktiven Bädern eine Metallabscheidung bewirken. Diese Metallabscheidung erfolgt dann sowohl wurzelförmig verankernd im mikroporösen Basismaterial, als auch außen aufliegend. So entsteht ein festhaftender Leiterzug.

Das erfindungsgemäße Verfahren kann sowohl mit flächig aufgebrachter Laserstrahlung und Maskentechnik in einer rationellen Massenfertigung eingesetzt werden, als auch maskenlos über eine beispielsweise NC-gesteuerte Führung eines punktförmig fokussierten Laserstrahls zur Prototypen- oder Kleinserienfertigung Anwendung finden.

Im folgenden wird die Erfindung an einem Ausführungsbeispiel erläutert:

Es werden 2,24 Masseteile Palladiumdiacetat in 100 Masseteilen Dimethylformamid gelöst. Außerdem werden 2,94 Masseteile des organischen Komplexbildners der Formel 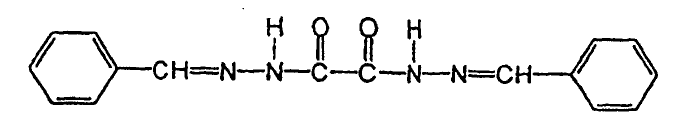 in 800 Masseteile Dimethylformamid eingebracht und durch Erwärmen gelöst. Beide Lösungen werden dann gemischt und zur Reaktion gebracht. Unmittelbar danach, bevor die Lösung abkühlt und der entstandene Palladiumkomplex ausfällt, wird eine mikroporöse Polyimid-Folie in der Lösung getränkt. Nach 10 Stunden Trocknung bei Raumtemperatur wird das so erhaltene Basismaterial mit einem Kr F-Excimerlaser, d. h. einem Excimerlaser mit einer Wellenlänge von 248 nm, über eine Maske bestrahlt. In den bestrahlten Bereichen wird dabei feinstverteiltes metallisches Palladium aus dem Komplex abgespalten. In einem handelsüblichen reduktiven, außenstromlosen Kupferbad scheidet sich selektiv in den bestrahlten Bereichen haftfest verankertes Kupfer ab. Die Leiterzüge sind ausgebildet; es liegt eine einsatzfähige flexible Schaltung vor.

Wie sich gezeigt hat, ist das erfindungsgemäße Verfahren auch zum Aufbringen von Leiterbahnstrukturen auf Schaltungsträger möglich, die aus anderen nichtleitenden Materialien mit mikroporöser Oberfläche, wie z. B. aus keramischen Basismaterialien oder auch aus Glas, bestehen.

## Patentansprüche

1. Verfahren zur Herstellung der Leiterbahnstrukturen, wobei eine schwermetallhaltige Komponente als Beschichtung auf ein nichtleitendes Trägermaterial aufgebracht wird, im Bereich der zu erzeugenden Leiterbahnstrukturen eine UV-Strahlung selektiv aufgebracht wird, wobei Schwermetallkeime freigesetzt werden, und dieser Bereich chemisch reduktiv metallisiert wird, **dadurch gekennzeichnet, dass** als die schwermetallhaltige Komponente ein nichtleitender organischer Schwermetallkomplex verwendet wird, bei dem mittels der UV-Strahlung durch ein Aufbrechen des Schwermetallkomplexes die Schwermetallkeime abgespalten werden und dass das Trägermaterial eine mikroporöse Oberfläche aufweist.

2. Verfahren nach Anspruch 1, **dadurch gekennzeichnet, dass** ein Pd-haltiger Schwermetallkomplex verwendet wird.

3. Verfahren nach Anspruch 1, **dadurch gekennzeichnet, dass** ein Pd-Komplex verwendet wird.

4. Verfahren nach Anspruch 3, **dadurch gekennzeichnet, dass** der Pd-Komplex gebildet wird, indem ein Palladiumsalz mit einem organischen Komplexbildner umgesetzt wird.

5. Verfahren nach den Ansprüchen 3 und 4, **dadurch gekennzeichnet, dass** der Pd-Komplex gebildet wird, indem Palladiumdiacetat mit einem organischen Komplexbildner umgesetzt und auskristallisiert wird.

6. Verfahren nach Anspruch 5, **dadurch gekennzeichnet, dass** als organischer Komplexbildner ein hochstabiler polyfunktioneller Chelatbildner mit mehreren Ligandenatomen, wie N, O, S, P, allein oder zusammen mit ionisierenden Gruppen, wie Hydroxyl- oder Carboxylgruppen, eingesetzt wird.

7. Verfahren nach den Ansprüchen 5 und 6, **dadurch gekennzeichnet, dass** als organischer Komplexbildner molekulare Kombinationen von sterisch gehinderten Aromaten und metallkomplexierenden Gruppen eingesetzt werden.

8. Verfahren nach den Ansprüchen 5, 6 und 7, **dadurch gekennzeichnet, dass** ein organischer Komplexbildner der Formel 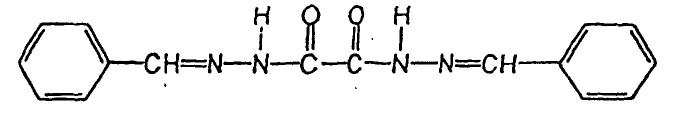 eingesetzt wird.

9. Verfahren nach einem oder mehreren der Ansprüche 1 bis 8, **dadurch gekennzeichnet, dass** der Schwermetallkomplex in einem Lösungsmittel gelöst auf ein poröses Trägermaterial bzw. auf ein Trägermaterial mit poröser Oberfläche aufgetragen wird.

10. Verfahren nach Anspruch 9, **dadurch gekennzeichnet, dass** der Schwermetallkomplex auf eine Polyimid-Membranfolie aufgetragen wird.

11. Verfahren nach den Ansprüchen 3 und 9 oder 10, **dadurch gekennzeichnet, dass** als Lösungsmittel für den Pd-Komplex Dimethylformamid oder Ethylacetat verwendet wird.

12. Verfahren nach einem oder mehreren der Ansprüche 1 bis 8, **dadurch gekennzeichnet, dass** der Schwermetallkomplex in ein Bindemittel, das eine poröse Struktur ausbildet, eingemischt und dann auf das Trägermaterial als Beschichtung aufgebracht wird.

13. Verfahren nach einem oder mehreren der Ansprüche 1 bis 12, **dadurch gekennzeichnet, dass** die Schwermetallkeime mittels eines Kr F-Excimerlasers mit einer Wellenlänge von 248 nm abgespalten werden.

## Claims

1. Method for producing conductor track structures, a heavy metal-containing component being applied as a coating to a non-conductive carrier material, UV radiation being selectively applied in the region of the conductor track structures to be produced, heavy metal nuclei being liberated and this region being metallised in a chemically reducing manner, **characterised in that** a non-conductive organic heavy metal complex is used as the heavy metal-containing component, in which the heavy metal nuclei are cleaved by breaking open of the heavy metal complex due to UV radiation, and **in that** the carrier material has a microporous surface.

2. Method according to claim 1, **characterised in that** a Pd-containing heavy metal complex is used.

3. Method according to claim 1, **characterised in that** a Pd complex is used.

4. Method according to claim 3, **characterised in that** the Pd complex is formed **in that** a palladium salt is reacted with an organic complexing agent.

5. Method according to claims 3 and 4, **characterised in that** the Pd complex is formed **in that** palladium diacetate is reacted with an organic complexing agent and is completely crystallised out.

6. Method according to claim 5, **characterised in that** a highly stable polyfunctional chelating agent with a plurality of ligand atoms, such N, O, S, P alone or together with ionising groups, such as hydroxyl or carboxyl groups, is used as an organic complexing agent.

7. Method according to claims 5 and 6, **characterised in that** molecular combinations of sterically hindered aromatic substances and metal-complexing groups are used as an organic complexing agent.

8. Method according to claims 5, 6 and 7, **characterised in that** an organic complexing agent of formula 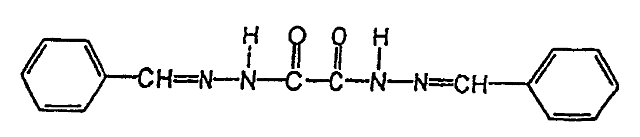 is used.

9. Method according to any one or more of claims 1 to 8, **characterised in that** the heavy metal complex dissolved in a solvent is applied to a porous carrier material or a carrier material with a porous surface.

10. Method according to claim 9, **characterised in that** the heavy metal complex is applied to a polyimide membrane film.

11. Method according to claims 3 and 9 or 10, **characterised in that** dimethyl formamide or ethyl acetate is used as solvent for the Pd complex.

12. Method according to any one or more of claims 1 to 8, **characterised in that** the heavy metal complex is mixed into a binder which forms a porous structure and is then applied to the carrier material as a coating.

13. Method according to any one or more of claims 1 to 12, **characterised in that** the heavy metal nuclei are cleaved by means of a Kr F excimer laser with a wavelength of 248 nm.

## Revendications

1. Procédé de fabrication des structures de pistes conductrices, dans lequel un composant contenant des métaux lourds est appliqué comme revêtement sur un matériau support non conducteur, un rayonnement UV est appliqué sélectivement dans la région des structures de pistes conductrices à produire, des germes de métaux lourds sont libérés, et cette région est métallisée de manière chimiquement réductrice, **caractérisé en ce que** l'on utilise, comme composant contenant des métaux lourds, un complexe de métaux lourds organique non conducteur, dans lequel des germes de métaux lourds sont séparés au moyen du rayonnement UV par ouverture du complexe de métaux lourds, et que le matériau support possède une surface microporeuse.

2. Procédé selon la revendication 1, **caractérisé en ce qu'**on utilise un complexe de métaux lourds contenant du Pd.

3. Procédé selon la revendication 1, **caractérisé en ce qu'**on utilise un complexe de Pd.

4. Procédé selon la revendication 3, **caractérisé en ce que** le complexe de Pd est formé en faisant réagir un sel de palladium avec un agent complexant organique.

5. Procédé selon les revendications 3 et 4, **caractérisé en ce que** le complexe de Pd est formé en faisant réagir et cristalliser du diacétate de palladium avec un agent complexant organique.

6. Procédé selon la revendication 5, **caractérisé en ce qu'**on utilise comme agent complexant organique un agent chélatant polyfonctionnel très stable possédant plusieurs atomes coordinants, comme N, O, S, P, seuls ou avec des groupes ionisants, comme des groupes hydroxyle ou carboxyle.

7. Procédé selon les revendications 5 et 6, **caractérisé en ce qu'**on utilise, comme agents complexants organiques, des combinaisons moléculaires de substances aromatiques stériquement entravés et de groupes complexant les métaux.

8. Procédé selon les revendications 5, 6 et 7, **caractérisé en ce qu'**on utilise un agent complexant organique de formule

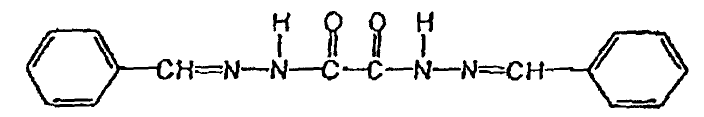

9. Procédé selon l'une ou plusieurs des revendications 1 à 8, **caractérisé en ce que** le complexe de métaux lourds est appliqué dissous dans un solvant sur un matériau support poreux ou sur un matériau support de surface poreuse.

10. Procédé selon la revendication 9, **caractérisé en ce que** le complexe de métaux lourds est appliqué sur une membrane de polyamide.

11. Procédé selon les revendications 3 et 9 ou 10, **caractérisé en ce qu'**on utilise comme solvant pour le complexe de Pd de la diméthylformamide ou de l'acétate d'éthyle.

12. Procédé selon l'une ou plusieurs des revendications 1 à 8, **caractérisé en ce que** le complexe de métaux lourds est incorporé par mélange dans un liant qui constitue une structure poreuse puis appliqué comme revêtement sur le matériau support.

13. Procédé selon l'une ou plusieurs des revendications 1 à 12, **caractérisé en ce que** les germes de métaux lourds sont séparés au moyen d'un laser Kr F-Excimer d'une longueur d'onde de 248 nm.
